# EUROPEAN PATENT APPLICATION

(11) **EP 1 403 918 A1**
(43) Date of publication of application: **31.03.2004**
(21) Application number: 02292358.5
(22) Date of filing: 25.09.2002
(51) Int. Cl.: H01L 21/768, H01L 31/18

(54) **A semiconductor device, its preparation**

(71) Applicant: CORNING INCORPORATED, Corning, N.Y. 14831 (US)
(72) Inventor: Guzman, Guillaume, 77250 Veneux-Les-Sablons (FR); Mechken, Sonia, 75011 Paris (FR)
(74) Representative: Le Roux, Martine

(57) **Abstract**

Polycrystalline silicon in semiconductor device is usually crystallized at high temperature annealing. Generally a low heat conducting underlayer is needed to protect substrate and silicon from high temperature crystallization. This invention proposes a new underlayer that improves silicon crystallization and protects substrate during the annealing process. The semiconductor device is a thin film transistor suitable for use in such applications as liquid crystal displays, light emitting diodes, imaging sensors and photovoltaic cells.

## Description

### BACKGROUND OF THE INVENTION

### FIELD OF THE INVENTION

The invention relates to a semiconductor device and a process for preparing it. The invention relates generally to photovoltaic components, imaging sensors and active matrix liquid crystal displays (AMLCDs), particularly active matrix organic light emitting devices (AMOLEDs or active matrix OLEDs). More particularly, the invention relates to the use of polycrystalline silicon in AMOLED thin film transistors (TFTs) and also in AMLCD TFTs.

### TECHNICAL BACKGROUND

Liquid crystal displays (LCDs) are flat panel displays which depend upon external sources of light for illumination. They are manufactured as segmented displays or in one of two basic configurations. The substrate needs (other than being transparent and capable of withstanding the chemical conditions to which it is exposed during display processing) of the two matrix types vary. The first type is intrinsic matrix addressed, relying upon the threshold properties of the liquid crystal material. The second is extrinsic matrix or active matrix (AM) addressed, in which an array of diodes, metal-insulator-metal (MIM) devices, or thin film transistors (TFTs) supplies an electronic switch to each pixel. In both cases, two sheets of glass form the structure of the display. The separation between the two sheets is the critical gap dimension, of the order of 5-10 µm.

An active matrix liquid crystal display is a flat panel display in which the display medium is liquid crystal and each picture element (pixel) is driven by an active device: a thin film transistor (TFT). Active matrix OLEDs are flat panel displays in which the display medium is an organic electroluminescent material and each picture element (pixel) is equally driven by a thin film transistor (TFT).

Currently, flat panel AMLCDs are predominantly manufactured using a-Si: H TFTs for the pixel switching device. However, this technology cannot be used for AMOLED TFTs. Indeed, a-Si: H TFTs cannot provide the electrical current necessary to drive AMOLED TFTs because of the very low mobility (0.001 cm²/Vs for holes, 0.5 to 1 cm²/Vs for the electrons) of the semiconductor material. Moreover, the meta-stability of the semiconductor material can lead to rapid degradation of the device. It has been recognised that polycrystalline silicon (polysilicon or poly-Si) TFT technology is the solution for AMOLED TFTs because the mobility exceeds the mobility of amorphous silicon (a-Si) TFTs by two orders of magnitude and also because the material is intrinsically stable.

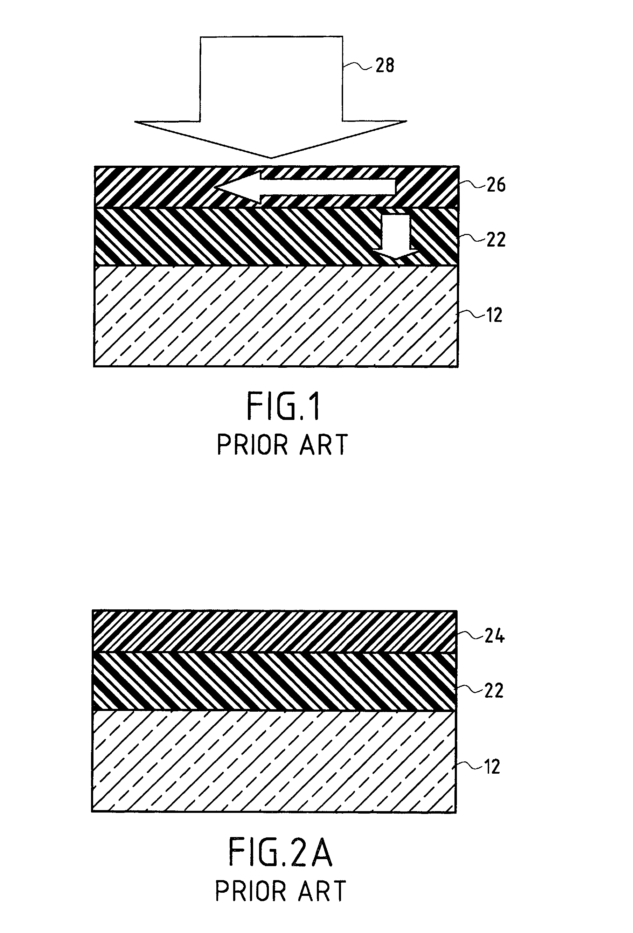

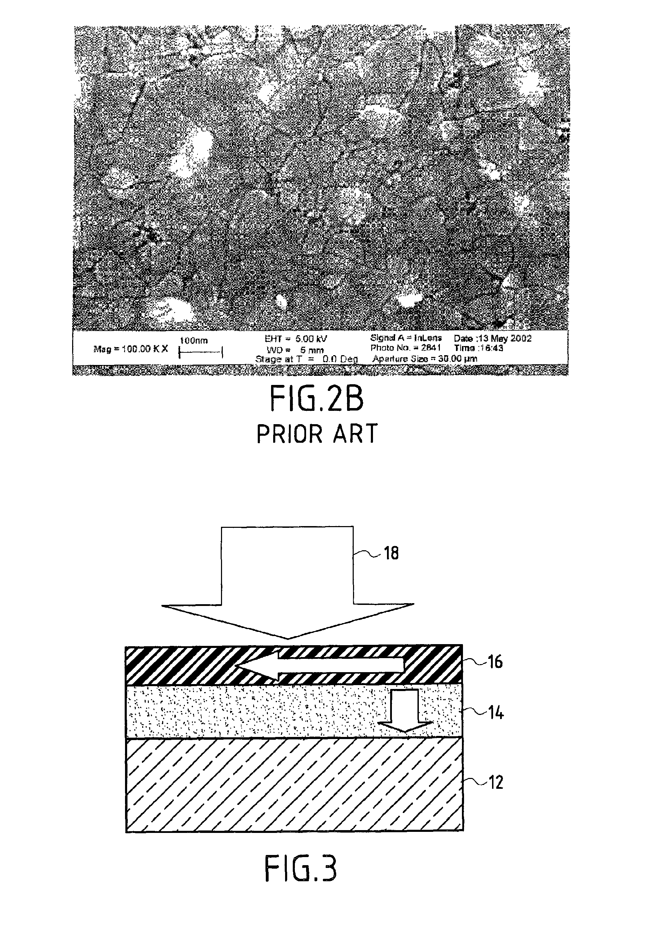

It is also recognized that next generation flat panel AMLCDs, require use of polysilicon TFTs instead of a-Si: H TFTs to allow integration of external electronics on the glass. It is expected that this will result in a more reliable and lower cost display. Achieving this will require the formation of polycrystalline silicon films on LCD substrates. To accomplish this, most technologies today employ laser annealing methods. Indeed, using a short wavelength (248 nm, 308 nm) a short pulse laser (typically 30 ns) it is possible to melt and very rapidly re-crystallize a thin film (20-80 nm) of amorphous silicon, in the order of nanoseconds. Using laser technology, the polycrystalline silicon film can be formed with almost no thermal damage to the underlying glass substrate. The glass substrate is usually protected with a silicon dioxide or a silicon nitride under layer deposited by PECVD before silicon deposition essentially to prevent impurity migration from the glass substrate to the molten silicon film during laser annealing. The prior art process is demonstrated in Figures 1, 2a and 2b. Figure 1 demonstrates the prior art method employed for the creation of the polysilicon layer. The substrate glass 12 is PECVD coated with silica 22, for example, and a layer of amorphous silicon 26 is then deposited on top of the silica underlayer 22. The silicon is melted and very rapidly recrystallized by laser annealing, represented schematically by the large arrow **28** in Figure 1, thereby creating the polysilicon layer **24** in Figure 2a. The heat generated from the laser light flows both laterally through the silicon film **26** as well as into the silica underlayer **22**, as demonstrated by the arrows in Figure 1. One of the disadvantages of such underlayers is that they create fixed charges at the interface between the underlayer and the polycrystalline silicon. This affects significantly electrical properties of TFTs particularly threshold voltage. For practical use of polysilicon TFT AMLCDS and AMOLEDS, both the high uniformity and reproducibility of Vₜₕ (threshold voltage) are required. Figure 2b is a SEM photograph of the surface polysilicon surface created by this prior art method.

One of the difficulties in advancing the above laser technology is that laser light energy is limited in its amount and very expensive. For instance, at the present time industrial lasers (lambda steel lasers) are limited to 1 joule at 300 Hz. This issue is particularly problematic for large area substrates. To maintain the same laser fluence (laser energy per unit area) necessary to crystallise a larger area, the laser has to be able to deliver higher energy.

In addition, in order to enable high integration with polysilicon films on LCD substrates, silicon mobility has to be increased. Generally, silicon mobility depends on silicon grain size. To enlarge grain size, solidification velocity has to be reduced. -In order to do this, thermal energy flow from the molten silicon film into the cool substrate must be suppressed. Especially for AMOLED TFTs, uniformity of the silicon crystallites has to be improved.

Various techniques have been proposed for overcoming the above needs with varying degrees of success. For example, it has been suggested to heat the glass substrate. However, this is limited to 400°C. A double pulse laser method has also been tried as well as using a dual beam where both sides of the substrate are irradiated by excimer laser light beams. In the field of energy generation from solar cells, porous silica under layers have been proposed to reduce heat diffusion during silicon crystallization in an excimer laser process.

There continues to be a need in the industry for new and improved methods for forming polycrystalline silicon films on glass substrates for use in semiconductor devices.

### SUMMARY OF THE INVENTION

One aspect of the invention is new coating material for semiconductor substrates and process for forming such coating on the substrate material.
In another aspect, the present invention describes a coating which improves polysilicon properties and reduces cost of the annealing process.

In a further aspect, the invention relates a semiconductor device which, in its most basic form is made up of (1) a substrate suitable for use in an electronic or integrated circuit and (2) a layer of polycrystalline silicon in which the substrate and the silicon are separated by (3) a layer of refractory polycrystalline material, preferably a layer of porous refractory polycrystalline material.

Additional features and advantages of the invention will be set forth in the detailed description which follows, and in part will be readily apparent to those skilled in the art from that description or recognized by practicing the invention as described herein, including the detailed description which follows, the claims, as well as the appended drawings.

It is to be understood that both the foregoing general description and the following detailed description present embodiments of the invention, and are intended to provide an overview or framework for understanding the nature and character of the invention as it is claimed. The accompanying drawings are included to provide a further understanding of the invention, and are incorporated into and constitute a part of this specification. The drawings illustrate various embodiments of the invention, and together with the description serve to explain the principles and operations of the invention.

### BRIEF DESCRIPTION OF THE DRAWINGS

Figure 1 is a cross-sectional representation of the prior art method for imparting a layer of polysilicon onto a substrate. The arrows directionally indicate heat flow during the annealing process.

Figure 2a is a cross-sectional representation of the typical layered structure of the prior art semiconductor device.

Figure 2b is a SEM photograph of polysilicon surface formed by utilizing the prior art crystallization of silicon after one shot KrF laser 20 ns pulse duration at 200 mJ/cm2. Conventional PECVD silica is indicated as the underlayer.

Figure 3 is a cross-sectional representation of the method of creating the layer structure of the present invention. Arrows illustrate heat flow during the annealing process.

Figure 4 is a cross-sectional representation of the layered structure of the present invention.

Figure 5 is a SEM photograph of surface polysilicon deposited on the refractory material (zirconia) after one shot KrF laser with 20 ns pulse duration at 200 mJ/cm².

### DETAILED DESCRIPTION OF THE PREFERRED EMBODIMENTS

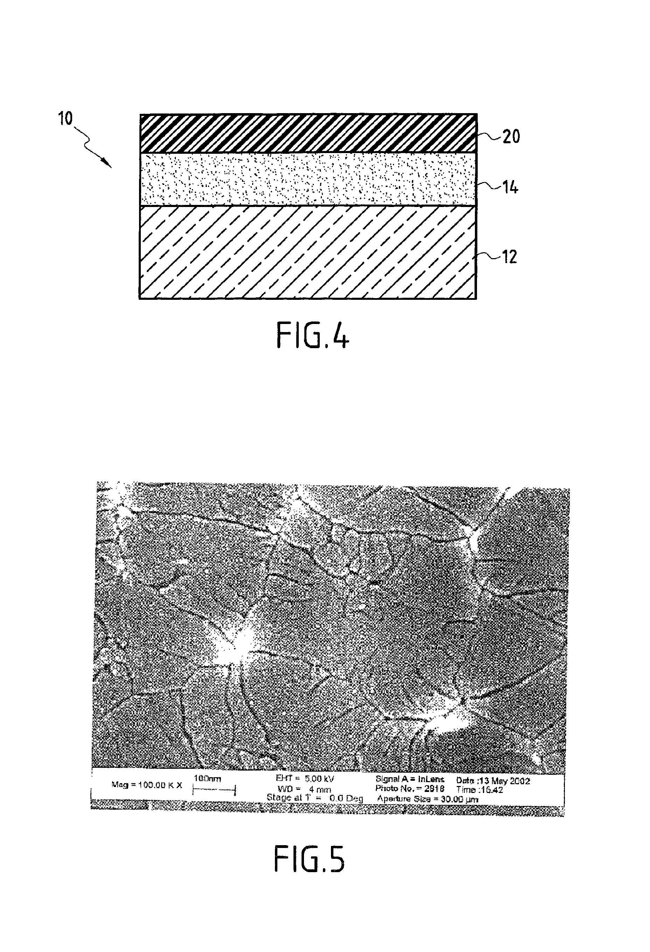

Reference will now be made in detail to the present preferred embodiment of the invention, an example of which is illustrated below and in the accompanying drawings. Whenever possible, the same reference numerals will be used throughout the drawings to refer to the same or like parts. One embodiment of the coated glass of the present invention is shown in Figure 4, and is designated generally by the reference numeral **10**.

In accordance with the invention, the coated substrate is made by coating any substrate material suitable for use in electronic and integrated circuits with a refractory polycrystalline material having low thermal conductivity, and preferably porous.

In the process contemplated by the invention and as illustrated in figure 3, a precursor chemical solution of the polycrystalline material is prepared in any compatible solvent followed by addition of an organic template to form a solution. A coating of the solution is deposited onto a clean glass substrate **12** using any appropriate coating method and heated to obtain a porous layer **14**. What coating method is employed will depend on such considerations as the desired coating thickness for example. Amorphous silicon **16** (e.g., silane and helium) is deposited on the coated substrate to a film thickness of about 50 nm and then heat treated in an inert atmosphere, for example, under a nitrogen atmosphere to eliminate residual hydrogen. The resulting amorphous silicon-coated glass is then irradiated with excimer laser, represented by a large arrow **18** in Figures 3, to crystallize the silicon and thereby form a polycrystalline silicon-coated glass substrate, essentially a semiconductor device (as demonstrated in Figure 4). Between the substrate **12** and the polysilicon top layer **20**, is the polycrystalline refractory material **14**. The range of laser fluence which can be used for this process will vary depending on the particular laser source. In experiments performed in support of this invention, a KrF laser was used and for a thickness of 50 nm of silicon film the laser fluences ranged from 90 mJ/cm²-300 mJ/cm². The range of laser fluence can go up to 600 mJ/cm² if a SOPRA laser is used. It is important that appropriate laser sources and fluence be used in order to crystallize the silicon and form a polysilicon coated substrate.

Silicon coating thickness is generally between 20 and 200 nm, preferably between 50 to 80 nm.

The polycrystalline refractory material **14** can be deposited by any of the known coating technologies in the art. For example, by wet chemistry such as sol-gel deposition, anodic oxidation or by physical and chemical deposition methods. The deposited layer has generally a thickness between 50 and 2 000 nm, preferably between 200 to 500 nm.

In a preferred embodiment, a thin film of amorphous silicon (50-80 nm) is deposited on a polycrystalline refractory coated LCD glass substrate for example, by PECVD (plasma enhanced chemical vapor deposition from a reactant gas mixture of SiH4 and He or hydrogen). The coated glass is annealed for 1h at 450°C under nitrogen atmosphere. Then, the silicon film is irradiated with an excimer laser (248 nm or 308 nm). As indicated in Figure 3, it is believed that the heat from the laser **18** is absorbed and transferred laterally through the amorphous silicon layer **16** as well as downwardly into the polycrystalline refractory layer **14** (heat transfer is indicated by arrows in Figure 3). During the annealing process, it is believed that crystallization is further induced by heat radiating back from the refractory material **14** to the silicon layer **16**. The result, which is illustrated by the SEM micrograph of Figure 5, shows good quality polycrystalline silicon having homogeneous silicon grains. The average grain size of the silicon can be increased with multiple laser shots.

In preferred embodiments, the resulting semiconductor device **10**, that is the polycrystalline silicon-coated substrate, is:
- a thin film transistor (TFT) suitable for such uses as liquid crystal displays (LCDs), light emitting diode (LEDs) to name a few, or
- a PIN diode suitable for applications selected from the group consisting of imaging sensors and photovoltaic devices.

Useful materials for the substrate **12** include, glass, glass-ceramics, ceramics, metal, plastic or composites of these materials. For LCD applications, we have found that glasses having certain properties are preferred. Active matrix LCDs can be classified into two categories depending upon the nature of the electrical switch located at each optical element or subpixel. Two of the most popular types of active matrix-addressed LCDs are those based on either amorphous (a-Si) or polycrystalline (p-Si) silicon thin film transistors (TFTs). Desirably, substrates for extrinsically addressed LCDs should be essentially free of alkali metal oxides to avoid the possibility of alkali metal contamination of the TFT. In addition, such substrates must be sufficiently chemically durable to withstand the reagents used during the manufacture of the TFT. It is also desirable that the expansion mismatch between the glass and the silicon present in the TFT array be maintained at a relatively low level even as processing temperatures for the substrates increase. The need for low thermal expansion mismatch is particularly desirable for "chip-on-glass" technology (COG) in which, as the name implies, the silicon chips are mounted directly on the glass substrate. Therefore, glasses useful for the present LCD devices are those in which the coefficient of thermal expansion closely match that of silicon, that is, linear expansion of between about 32-46 X 10⁻⁷/°C, most preferably 32-40X10⁻⁷/°C in the temperature range of 25°-300°C.

Recent improvements in the resolution of extrinsically addressed LCDs have led to the development of another requirement for the glass substrate, namely, high glass strain point which is an indication of the thermal shrinkage of the glass. The lower the strain point, the greater is this thermal shrinkage. Low thermal shrinkage is desirable for precise alignment during successive photolithographic and other patterning steps during the TFT processing. Consequently, glasses having higher strain points are generally preferred for extrinsically addressed LCDs, particularly those which employ polysilicon TFT technology. Thus, there has been considerable research to develop glasses demonstrating high strain points so that thermal shrinkage is minimized during device processing. Corning Code 1737 glass (available from Coming Incorporated, Coming, NY), which has one of the highest strain points, if not the highest (666°C) in the AMLCD substrate industry and is rapidly becoming an industry standard is a preferred glass substrate for the present LCD devices.

Most preferably, in addition to the above desirable properties useful glass substrates are those that are free of arsenic and other environmentally harmful components. Another particularly preferred substrate is a glass which is available from Corning Incorporated under the product name, EAGLE2000.

One particularly useful glass composition for the present LCD substrate is characterized by having a strain point higher than 630°C., a linear coefficient of thermal expansion over the temperature range of 25°-300°C of between 32-46X10-7/°C. The glass is essentially free from alkali metal oxides and has the following composition, expressed in terms of mole percent on the oxide basis:

| | | | |
|---|---|---|---|
| SiO₂ | 64-73 | MgO | 0-5 |
| Al₂O₃ | 9.5-14 | CaO | 1-13 |
| B₂O₃ | 5-17 | SrO | 0-8 |
| TiO₂ | 0-5 | BaO | 0-14 |
| Ta₂O₅ | 0-5. | | |

Examples of typical fining agents for the above composition include Sb₂O₃, CeO₂, SnO₂, Fe₂O₃ ,and mixtures of these.

Useful glass-ceramic materials for the substrate 12 include, without limitation, silicate-based glass ceramic materials containing silica-based glass phase and a crystal phase. One particularly useful class of useful glass-ceramic materials having the following composition as calculated in weight percent on an oxide basis: 45-70 SiO₂, 14-28 Al₂O₃, 4-13 ZnO, 0-8 MgO, 0-10 TiO₂ 0-10 ZrO₂ 0-15 Cs₂O, 0-5 BaO, ZnO+MgO in combination being greater than or equal to about 8, and TiO₂+ZrO₂ in combination being greater than about 4. Preferably, the glass ceramic substrate exhibits a strain point of 850°C or above. More preferably, the glass-ceramic material exhibits a shrinkage, when exposed to 900°C for 6 hours, which is less than 100 ppm. Even more preferably are glass-ceramic materials exhibiting coefficients of thermal expansion between about 22-42 X 10⁻⁷/°C, over the temperature range of 25-300°C, more preferably between about 30-42 X 10⁻⁷/°C, and most preferably between about 35-40 X 10⁻⁷/°C, providing a close thermal expansion match to silicon.

Useful coating materials for the refractory polycrystalline layer 14 include refractory oxide ceramics of the elements such as Al, Mg, Ti, Zr, Y, Ca, Mo, Ce, Hf, Ta, B, V and combinations of these, preferably oxides having low thermal conductivity and/or high electrical permittivity. Some amounts of silica may also be combined with the above materials. In addition, carbides, nitrides, borides and non-oxide refractory materials having low thermal conductivity may also be used. Polycrystalline zirconia has been found to be a particularly useful refractory coating material for the present invention. The refractory coating may be created from a material that is polycrystalline, a material that is polycrystaline and porous, a material that is polycrystalline with crystal parameters near to those of silicon, or most preferably, a material that is polycrystalline with crystal parameters near to those of silicon and porous. The said refractory material has advantageously a low thermal conductivity (lower than that of the substrate) and a high electrical permittivity (higher, far higher than that of the substrate).

Preferably, when applied to the substrate the refractory coating **14** is porous in nature. The coating can be applied by any suitable coating techniques such as sol-gel, chemical or physical deposition techniques, or by electron, ion, atom or laser beam processes.

Amorphous silicon precursor **16** can be deposited on the refractory layer by any number of techniques. One particularly useful technique is by PECVD which involves silicon deposition from a gas mixture of silane SiH₄ and hydrogen at 300 °C by plasma enhanced chemical vapor deposition. PECVD is usually the preferred deposition technique because large area deposition is possible at a temperature lower than the strain point of glass. The silicon is then crystallized by heat treatment. Examples of heat treatments include, laser annealing techniques, excimer laser annealing, microwave and thermal annealing to name a few.

### Examples

The invention will be further clarified by the following example.

### EXAMPLE 1

(a) A zirconia precursor chemical solution was prepared from the hydrolysis and condensation of an organo-zirconium compound, in this case zirconium alkoxide, in ethanol followed by the addition of polyethylene glycol.

(b) A coating of the zirconium solution was deposited by dip coating onto a cleaned 1737 glass substrate.

(c) The deposited coating was heat treated at 550°C during 1 hour to obtain a porous zirconia film with thickness of about 220 nm and surface roughness of about 0.5 nm. Cubic crystalline phase was measured by XRD. SEM analysis of the cross section revealed a relatively porous structure. The coated substrate was then allowed to cool to room temperature.

(d) Amorphous silicon (silane and helium), was deposited on the zirconia coated 1737 glass at 280°C to a thickness of about 50 nm.

(e) The sample was heat treated at 450°C for a duration of about one hour under a nitrogen atmosphere to eliminate residual hydrogen.

(f) The sample was then irradiated with a KrF excimer laser with the fluences in the range of 90 mJ/cm²-260mJ/cm².

SEM characterization of the irradiated samples shown in Figures 2b and 5 confirmed the following:
- Increased silicon grain size with zirconia underlayer,
- Increased silicon grain homogeneity,
- High material stability to high energy fluences (> 260 mJ/cm²),
- High stability to multi-shot laser irradiation (up to ten shots tested).

Other advantages of the present invention will be apparent to those skilled in the art. For example, with respect to zirconia coated LCDs, we have observed the following advantages:
- Thermal conduction of porous zirconia-based layers (20% of porosity) can be reduced up to values close to or lower than silicon oxide. Porosity reduces the impact of zirconia thermal expansion.
- Zirconia is a more refractory material than silica and has lower chemical reactivity and higher thermal stability.
- Zirconia produces very high crystalline quality silicon due to the fact that its crystalline parameters closely match those of silicon. For example, the unit cell parameters of zirconia (0.5 to 0.53 nm) are close to that of silicon (0.542 nm). And because the lattice match is good, it can induce texturation after laser annealing of silicon layers.
- As an additional feature, zirconia has high permittivity and for this reason also provides good electrical insulation. It may also be conceived to use the zirconia layer as an insulating gate oxide.
- Finally, zirconia polysilicon coated glass is produced having homogeneous silicon grains.

The present process results in a marked reduction in the cost of excimer laser crystallization process for panel display makers especially on large area substrates without heating the glass substrate. Laser energy is limited in its amount and expense. With a low thermal conductivity coating, a gain of about 30% is made in laser energy density. This is obtained without heating the substrate. Also, thermal insulation of the porous coating protects the glass substrate during laser annealing (pulsed excimer or visible laser, CW laser). Finally, the refractory coating prevents vertical heat conduction and compensates for the waste of laser energy that tends to result when using projection optics (masks). This advantage becomes even more significant in second-generation laser crystallization systems such as in sequential lateral solidification processes where it is expected that use of refractory coatings will directly reduce costs and extend the useful life of the optics.

It will be apparent to those skilled in the art that various modifications and variations can be made to the present invention without departing from the spirit and scope of the invention. Thus it is intended that the present invention cover the modifications and variations of this invention provided they come within the scope of the appended claims and their equivalents.

## Claims

1. A semiconductor device (10) comprising :
a substrate (12) suitable for use in electronic and integrated circuits;
a layer of refractory polycrystalline material (14) formed on at least a portion of the said substrate (12); and
a layer of polycrystalline silicon (20) formed on the said refractory layer ( 14).

2. The semiconductor device (10) according to claim 1 wherein said substrate (12) is glass, glass-ceramic, ceramic, metal or plastic.

3. The semiconductor device (10) according to claim 1 or 2 wherein said refractory material is an oxide.

4. The semiconductor device (10) according to claim 1 or 2 wherein said refractory material is a carbide, nitride or boride.

5. The semiconductor device (10) according to claim 3 or 4 wherein said refractory material is an oxide, a carbide, nitride or boride of an element selected from the group consisting of Al, Mg, Ti, Zr, Y, Ca, Mo, Ce, Hf, Ta, B, V and a combination of these.

6. The semiconductor device (10) according to claim 5, wherein said refractory material is polycrystalline zirconia.

7. The semiconductor device (10) according to any one of claims 3 to 6 wherein said refractory material contains silicon.

8. The semiconductor device (10) according to any one of claims 1 to 7 wherein said refractory material has a low thermal conductivity and a high electrical permittivity.

9. The semiconductor device (10) according to any one of claims 1 to 8 wherein said refractory material is porous.

10. The semiconductor device (10) according to any one of claims 1 to 9 wherein said refractory material has at least one crystal parameter close to that of crystalline silicon.

11. A process for preparing a semiconductor device (10) according to any one of claims 1 to 10 wherein it comprises :
- a first step of forming a layer of refractory polycrystalline material (14) on at least a portion of a substrate (12) suitable for use in electronic and integrated circuits;
- a second step of forming a layer of polycrystalline silicon (20) on said refractory layer (14).

12. The process according to claim 11 wherein the said first step includes the deposit of the said material by one of the processes selected from the group consisting of the sol-gel technique, the anodic oxidation, the chemical or physical vapor deposition processes, the electron, ion, atom or laser beam processes.

13. The process according to one of claims 11 or 12 wherein the said second step includes the deposit of the silicon by either chemical vapor deposition methods or physical vapor deposition methods.

14. The process according to claim 13 wherein the deposited silicon is crystallized by laser annealing techniques.

15. The process according to claim 14 wherein the deposited silicon is annealed using an excimer laser.

16. The process according to claim 13 wherein the deposited silicon is crystallized by either microwave annealing, furnace annealing or lamp annealing.

17. The semiconductor device (10) according to any one of claims 1 to 10 and/or prepared according to any one of claims 11 to 16 wherein said device is a thin film transistor (TFT) suitable for applications selected from the group consisting of liquid crystal displays (LCDs) and light emitting diodes (LEDs).

18. The semiconductor device (10) according to anyone of claims 1 to 10 and/or prepared according to any one of claims 11 to 16 wherein said device is a PIN diode suitable for applications selected from the group consisting of imaging sensors and photovoltaic devices.
